# EUROPEAN PATENT APPLICATION

(11) **EP 3 444 671 A1**
(43) Date of publication of application: **20.02.2019**
(21) Application number: 17186841.7
(22) Date of filing: 18.08.2017
(51) Int. Cl.: G03F 7/00, G03F 7/40

(54) **MAKING A MASK LAYER**

(71) Applicant: IMEC vzw, 3001 Leuven (BE)
(72) Inventor: CHAN, Boon Teik, B - 3001 Leuven (BE); DE MARNEFFE, Jean-Francois, 3001 Leuven (BE)
(74) Representative: DenK iP

(57) **Abstract**

In a first aspect, the present invention relates to a method for making a mask layer, comprising:
a. providing a substrate (100, 200, 300) having a patterned layer (400) thereon, the patterned layer (400) comprising at least one opening (500), the opening (500) exposing the substrate (100, 200, 300) and having a width, and
b. infiltrating the patterned layer (400) with a metal or ceramic material, selectively with respect to the substrate (100, 200, 300);
wherein step b is performed to such an extent that the width (w) is reduced by at least 20%, preferably at least 35%, yet more preferably at least 50%.

## Description

### Technical field of the invention

The present invention relates to mask layers for use in the fabrication of devices, such as for instance semiconductor devices, and in particular to the reduction of a width of an opening in such a mask layer.

### Background of the invention

Current optical lithography techniques have limits regarding the minimal feature sizes they can achieve. This fact is problematic in several industries and is most critical in the semiconductor industry where, for instance, the continued scaling of nano-electronic transistors pushes for the patterning of features in sizes beyond the capabilities of current optical lithography techniques. A way to reduce the dimensions (e.g. width) of an opening in a mask layer, such as a trench or hole, obtained through a lithographic technique is to coat the insides of the opening using an atomic layer deposition (ALD) technique (see H.-S. Moon et al, Advanced functional materials, Vol. 24, Issue 27, p.4343-4348). However, this method typically also coats the bottom of the opening, which is a big concern when the pattern of the mask must be transferred to the underlying layers. Indeed, when nanometer size features are targeted and if an etching technique is used which can open the coated bottom, then often also the sides will be removed and the reduction of the dimensions of the opening may be partly or entirely undone. Opening the bottom selectively with respect to the sides, when both are made of the same material, is a non-trivial challenge to resolve for nanometer size features because even directional etching techniques are not perfectly anisotropic. Furthermore, the ALD coating typically comes with adhesion issues to or stress issues with the material it is coated on, which deteriorate the quality of the pattern that can be transferred. Moreover, ALD typically has to be performed on a hydrophilic surface, limiting the range of materials that can be used. Additionally, when the ALD coating is etched away during pattern transfer to the point of opening up to the material underneath, which almost inevitably happens, the further etching may become difficult to control as the etch rate between the ALD coating and the underlying material typically differs considerably.

As such, there is still a need in the art for methods for making mask layers which resolve some or all of the issues outlined above.

### Summary of the invention

It is an object of the present invention to provide good mask layers and methods for making the same. The above objective is accomplished by a method, an assembly or a use according to the present invention.

It is an advantage of embodiments of the present invention that at least one of the width and the length of a patterned opening, such as a trench or hole, can be reduced. It is a further advantage of embodiments of the present invention that the reduced width can be smaller than obtainable with conventional patterning and etching techniques. It is yet a further advantage of embodiments of the present invention that the reduction in width and/or length of an opening can be well controlled with relative ease.

It is an advantage of embodiments of the present invention that the etch selectivity of the underlying substrate with respect to the mask layer can be improved.

It is an advantage of embodiments of the present invention that the etch resistance of the mask layer can be improved.

It is an advantage of embodiments of the present invention that the lifetime of the mask layer during storage can be improved.

It is an advantage of embodiments of the present invention that they can be relatively cheap and easy to perform.

In a first aspect, the present invention relates to a method for making a mask layer, comprising:
a. providing a substrate having a patterned layer thereon, the patterned layer comprising at least one opening, the opening exposing the substrate and having a width and a length, and
b. infiltrating the patterned layer with a metal or ceramic material, selectively with respect to the substrate;
wherein step b is performed to such an extent that at least one of the width and the length is reduced by at least 20%, preferably at least 35%, yet more preferably at least 50%, thereby forming the mask.

The present invention may further relate to a method for patterning a substrate, comprising performing the method according to any embodiment of the first aspect and further comprising performing a step c, after step b, of:
c. selectively etching, through the opening having the reduced width and/or length, the substrate with respect to the mask.

In a second aspect, the present invention relates to an assembly comprising a mask layer on a substrate, obtainable by the method according to any embodiment of the first aspect. In particular it relates to an assembly comprising a mask layer on a substrate, the mask layer being a patterned layer comprising at least one opening exposing the substrate, the patterned layer being infiltrated with a concentration of a metal or ceramic material, the substrate being not infiltrated with the metal or ceramic material or being infiltrated with a lower concentration thereof

In a third aspect, the present invention relates to a use of sequential infiltration synthesis for reducing a width and/or a length of an opening in a patterned layer.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a graph showing the atomic percentage in function of the emission angle for different atomic orbitals, obtained using angle-resolved XPS on a sample in accordance with an example of the present invention.
Fig. 2 is a graph showing the elemental composition in function of the depth, obtained using ERD on a sample in accordance with an example of the present invention.
Fig. 3 shows elemental analysis mappings obtained using transmission electron microscopy energy dispersive x-ray spectroscopy, for a sample in accordance with an example of the present invention.
Fig. 4 is a graph of the thickness of a polyphtalaldehyde (PPA) film in function of the number of cycles for a SIS process performed at 80°C (triangles) and 90 °C (squares), in accordance with an example of the present invention.
Fig. 5 is a schematic representation of different steps in the formation of a mask layer on a substrate and a subsequent pattern transfer into the substrate, in accordance with embodiments of the present invention.
Fig. 6 shows atomic force microscopy depth profiles along a direction x after one, two or four SIS cycles, for samples according to embodiments of the present invention.
Fig. 7 is a graph of the measured PPA etch rate for an N₂/H₂ plasma etch in function of the number of SIS cycles, for samples according to embodiments of the present invention.
Fig. 8 shows atomic force microscopy depth profiles along a direction x after different steps in the formation of a mask layer on a substrate and subsequent pattern transfer, for samples according to embodiments of the present invention.
Fig. 9 are schematic representations of top views of a patterned layer on a substrate (top) and mask layer on the substrate (bottom) for openings differing in shape.
Figure 10 defines the length (I), width (w) and depth (d) of a right cylinder opening having irregular bases.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

Although the invention is not limited to a particular type of device, reference will be made to transistors. These are devices having a first main electrode such as a drain, a second main electrode such as a source and a control electrode such as a gate for controlling the flow of electrical charges between the first and second main electrodes.

The following terms are provided solely to aid in the understanding of the invention.

As used herein, when a metal or ceramic material is said to infiltrate a first material selectively with respect to a second material, this means that the first material is infiltrated more than the second material. Preferably, the metal or ceramic material would infiltrate the first material at least twice as much, more preferably at least five times as much, yet more preferably at least 10 times as much, as the second material. In some preferred embodiments, the second material may be substantially not infiltrated by the metal or ceramic material.

As used herein, when a first material is said to be etched selectively with respect to a second material, this means that the first material is etched faster than the second material. Preferably, the etching process would etch the first material at least twice faster, or more preferably at least five times faster, yet more preferably at least 10 times faster, than the second material. In some preferred embodiments, the second material may be substantially not etched by the etching process.

As used herein, an opening has a depth, a width and a length. If the opening has the shape of a cuboid having a face parallel to the surface of the substrate, the depth of the opening is the dimension of the cuboid measured perpendicularly to the surface of the substrate; the length of the opening is the extent of its longest edge parallel to the surface of the substrate; and the width of the opening is the extent of its shortest edge parallel to the surface of the substrate.

The present application is applicable to openings of any shape. The opening may, for instance, be irregular along its length, width and depth. The opening will often be a right cylinder, for instance, a right cylinder having polygonal bases of 3 or more sides, ellipsoidal bases or irregular bases. To accommodate for this large variety of suitable opening shapes, the notions of length, width, and depth as used herein are defined as follow. As used herein, the depth, length, and width of an opening is respectively the depth, length, and width of its minimum bounding cuboid having a face parallel to the surface of the substrate.

The minimum bounding cuboid of an opening is the cuboid of smallest volume which comprises the entirety of the opening and which has a face parallel to the opening.

In a first aspect, the present invention relates to a method for making a mask layer, comprising:
a. providing a substrate having a patterned layer thereon, the patterned layer comprising at least one opening, the opening exposing the substrate and having a width and a length, and
b. infiltrating the patterned layer with a metal or ceramic material, selectively with respect to the substrate;
wherein step b is performed to such an extent that at least one of the width and the length is reduced by at least 20%, preferably at least 35%, yet more preferably at least 50%, thereby forming the mask.

It was surprisingly found within the present invention that infiltration of a patterned layer leads to an expansion of the patterned layer, typically both perpendicular and parallel to the substrate, and can, therefore, be used to reduce the width and/or the length of an opening therein. This allows the formation of an opening with a reduced width smaller than could be obtained without infiltration. Furthermore, infiltration with the metal or ceramic material allows the selectivity of the substrate etching with respect to the patterned layer to be increased. It also allows the substrate resistance of the patterned layer to be increased. Additionally, infiltration can be regarded as a bulk modification of the patterned layer (as opposed to a mere surface modification). As such, the problems related to ALD coating as described in the background of the invention (e.g. adhesion and stress issues, uncontrolled etching after opening up of the ALD coating, etc.) are addressed.

The mask layer may typically be used in patterning the substrate underneath (cf. infra). The mask layer may for example function as a patterned hardmask layer during the pattern transfer.

The substrate may typically comprise a layer to be patterned. The layer to be patterned may, for example, be a semiconductor layer (e.g. a Si wafer, a Si nanowire, a MoS₂ nanoribbon or a graphene layer) or a dielectric layer (e.g. a layer of low-k material). The substrate may further comprise a hardmask layer (e.g. Si₃N₄ or SiO₂), above and typically on the layer to be patterned. The hardmask layer may, for example, be from 10 to 15 nm thick, e.g. 13 nm thick. A hardmask layer above the layer to be patterned is advantageously useful in achieving a high quality of the transferred pattern. In embodiments, the hardmask may be a combination of an inorganic hardmask on an organic hardmask. For instance, the hardmask may be a SiO₂ inorganic hardmask layer provided on an APF™ film (Applied Materials, an amorphous carbon (a-C) deposited by CVD which precursors are acetylene (C₂H₂) and propane (C₃H₆)) or a JSR HM8006™ film (an aromatic copolymer which contains naphthalene as a portion of the aromatic structure). The substrate may further comprise a soft material (e.g. having a Mohs hardness of 6 or below, preferably 2 or below, yet more preferably 1 or below), such as a softmask layer or a polymer layer, above the layer to be patterned and on the hardmask when a hardmask is present. A softmask layer is advantageously useful in achieving a high quality of the transferred pattern. Preferably, the opening exposes a surface of the substrate and the surface comprises the soft material. Particularly when a scanning probe lithography is used to pattern the opening in the patterned layer (cf. infra), the soft material preferably directly underlies the patterned layer. This is advantageous for the scanning probe tip to experience less wear.

In embodiments, the opening may be a trench or a hole (e.g. a via). In embodiments, the width may measure 100 nm or less, preferably 50 nm or less, yet more preferably 20 nm or less, before step b. The width may for example measure from 7 to 20 nm, preferably from 10 to 15 nm, e.g. from 11 to 12 nm. In embodiments, the width may measure from 7 to 20 nm, preferably from 10 to 15 nm, such as from 11 to 12 nm, before step b and may measure from 1 to 10 nm, preferably from 2 to 5 nm, after step b. A sub 10 nm or sub 5 nm width after step b is advantageously desired in a variety of applications and is typically difficult to achieve using current techniques.

In embodiments, the patterned layer may be a patterned resist layer and step a may comprise:
a1. providing a substrate having a resist layer thereon, and
a2. patterning the opening into the resist layer using lithography, such as a thermal scanning probe lithography.
The lithography is preferably a scanning lithography. The scanning lithography preferably selected from a laser-scanning lithography, an electron beam lithography or a thermal scanning probe lithography. These last techniques are for instance well suited for patterning amorphous organic materials comprising oxygen atoms in their structure and having a glass transition temperature above 100°C (such as polyphthalaldehyde, PPA).
Scanning lithography encompasses an ensemble of lithographic techniques which use setups comparable to scanning probe microscopes and which typically advantageously allow sub diffraction limit resolutions (e.g. down to 10 nm and below). In scanning lithography, a scanning element (e.g. probe, laser or electron beam) is used to pattern a layer, for example, based on mechanical, thermal, chemical, optical or electrical interactions (or combinations thereof). A setup for scanning lithography may typically allow both scanning lithography and scanning microscopy to be performed; this advantageously allows the resist layer to be scanned and imaged prior to patterning, e.g. allowing the right target position to be determined, and/or after patterning, e.g. allowing the results of the patterning to be analysed and to be determined whether any corrections need to be made. In preferred embodiments, the scanning lithography may remove material from the resist layer to form the opening. An ablative scanning lithography advantageously foregoes the need for an additional development step. In other embodiments, the scanning lithography may change (e.g. oxidize) the nature of a section of the resist layer and patterning the opening may further comprise removing a section of the resist layer having a first nature selectively with respect to a section of the resist layer having a second nature.

In preferred embodiments, the scanning lithography may be a thermal scanning probe lithography. Thermal scanning probe lithography is a technique which is typically advantageously ablative and well controllable while allowing features of 9 nm or below with a pitch of 9.5 nm or below to be patterned. It may advantageously be a maskless, all-dry, auto-correcting, table-top and/or direct overlay patterning technique and may have 3D patterning capability (see Pires et al., Science, 2010, vol. 328, issue 5979, pp 732-735). The thermal scanning probe may be a Si cantilever configured with a heatable tip. The thermal scanning probe may be useable for writing (i.e. patterning; scanning probe lithography) and imaging (i.e. scanning probe microscopy). In embodiments, the tip may be heated up to 800°C for patterning. In embodiments, the tip may be cooled (e.g. for 6 µs) prior to imaging. In embodiments, patterning the opening may comprise placing the tip into contact (e.g. electrostatically) with the resist layer for 1 to 5 µs. In embodiments, step a2 may comprise:
- scanning a surface of the resist layer,
- thermally patterning a first section (e.g. a line) of the resist layer,
- cooling the tip,
- imaging the resist layer and analyzing the results; and
optionally repeating said steps on a further section.

In embodiments, the patterned layer may be from 5 to 20 nm thick, preferably from 9 to 11 nm thick, e.g. 10 nm thick. The patterned layer is typically a resist layer in which a metal or ceramic material can infiltrate. In other words, the patterned layer is typically not so dense to the point that the metal or ceramic material cannot infiltrate therein, e.g. the first and/or second precursor cannot infiltrate therein. Examples of good such materials are organic materials comprising oxygen atoms in their structure. Preferably, the patterned layer may be made of a material having a glass transition temperature above 100°C, preferably above 120°C. The patterned layer is preferably amorphous. Particularly suitable are amorphous organic materials comprising oxygen atoms in their structure and having a glass transition temperature above 100°C. In embodiments, the patterned layer may be selected from molecular glasses having oxygen in their structures and polyphthalaldehyde (PPA). An example of suitable molecular glass is the following:

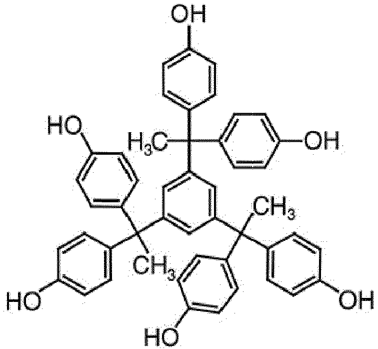

In preferred embodiments, the patterned layer may comprise a polyphthalaldehyde (PPA). In embodiments, the resist layer may comprise a polyphthalaldehyde. The polyphthalaldehyde may comprise the following structure in its general formula. 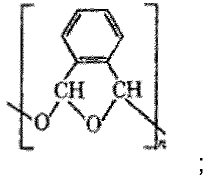 wherein *n* is from 3 to 50000, preferably from 500 to 30000. For instance, the polyphthalaldehyde may be a polymer or an oligomer. It may be linear or a cyclic. If it is a linear polymer, the nature of the end-groups is not crucial. Some suitable linear polyphthalaldehyde are commercially available having a trichlorocarbamoyl end-group. Polyphthalaldehydes are materials which can advantageously be patterned using thermal scanning probe lithography and which can advantageously be infiltrated by a metal or ceramic material (e.g. they comprise ether groups to which a first precursor in a SIS process can bind; cf. infra).

In embodiments, the ceramic material may be a metal oxide or a metalloid oxide such as an aluminum oxide, a titanium oxide, a silicon oxide, a ruthenium oxide or a hafnium oxide. These oxides can advantageously be infiltrated into the patterned layer, e.g. using a SIS process. In preferred embodiments, the ceramic material may be aluminum oxide (e.g. Al₂O₃). The chemistry of infiltrating a layer with aluminum oxide using a SIS process is advantageously well studied and understood.

In embodiments, step b may comprise a sequential infiltration synthesis (SIS).

In embodiments, the sequential infiltration synthesis may comprise:
b1. exposing the patterned layer to a first metal or ceramic material precursor, and subsequently
b2. exposing the patterned layer to a second metal or ceramic material precursor.
As used herein the term "*metal or ceramic material precursor*" relates to a precursor in the formation of a metal or of a ceramic material. In the present invention, preferred types of "metal or ceramic material precursor" are precursors to metal oxides or to metalloid oxides.

Infiltrating the patterned layer with a metal or ceramic material can advantageously comprise exposing the patterned layer to a first metal or ceramic material precursor, thereby typically absorbing the first metal or ceramic material precursor in the patterned layer, and subsequently exposing the patterned layer to a second metal or ceramic material precursor, thereby typically chemically reacting both precursors to form the metal or ceramic material. The first and second metal or ceramic material precursors are typically reagents in the formation the metal or ceramic material and are not typically metals or ceramic materials themselves. In preferred embodiments, the first and/or second metal or ceramic material precursors may be in a gaseous phase. In yet more preferred embodiments, both the first and second metal or ceramic material precursors may be in a gaseous phase. The SIS process is typically performed in a reaction chamber. Typically, directly after step b1, a step of purging the reaction chamber with an inert gas (e.g. N₂) is performed. Typically, directly after step b2, a step of purging the reaction chamber with an inert gas (e.g. N₂) is performed. SIS may preferentially be performed at a temperature of from 10 °C to 110 °C, preferably from 20 °C to 90 °C. A polyphtalaldehyde may, for example, decompose at a temperature of around 110 to 140 °C. In order to improve the pattern fidelity, the SIS temperature may advantageously be lower, e.g. 25°C.

The first precursor of the metal or ceramic material typically comprises a metal atom in its general formula. For instance, it can be an organometallic compound The second precursor may be an oxidant. In embodiments, the first precursor may be trimethylaluminium and the second precursor may be an oxidant (e.g. water). Other examples are RuO₄ for the first precursor and an oxidant (e.g. water) for the second precursor; TiCl₄ for the first precursor and an oxidant (e.g. water) for the second precursor; SiCl₄ for the first precursor and an oxidant (e.g. water) for the second precursor. In general, for the first precursor, any CVD/ALD precursors which can infiltrate the patterned layer selectively with respect to the substrate may be used. Preferably, the first precursor reacts with the second precursor at a temperature of from 10 °C to 110 °C, preferably from 20 °C to 90 °C. Typically, the first precursor is able to infiltrate the patterned layer. The infiltrated ceramic material can advantageously be obtained through an oxidation of the first ceramic material precursor by means of the second ceramic material precursor (here typically an oxidant).

A SIS process is an advantageously suitable way for infiltrating the patterned layer in a controlled fashion; through a (repeatable) sequence of exposure to two (or more) metal or ceramic material precursors. Multiple parameters (e.g. exposure time, temperature or partial pressure of the precursors) can be adapted within this process to achieve the desired infiltration. Use of trimethylaluminium within this process as a ceramic material precursor and subsequent oxidation by exposure to water, forming aluminum oxide infiltrated into the patterned layer, is advantageously well understood.

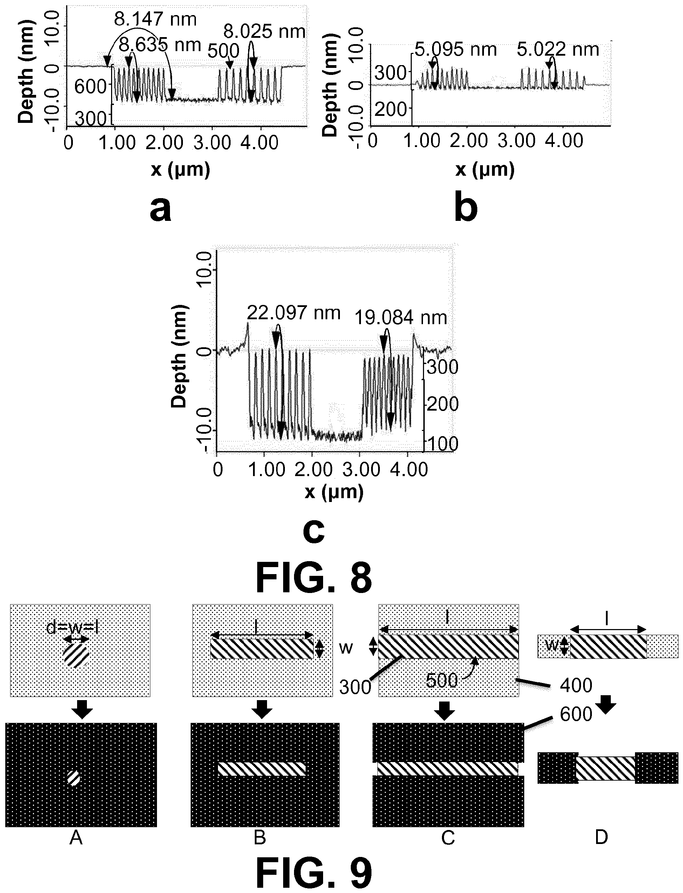

Step b is performed to such an extent that at least one of the width and the length of the opening is reduced. Typically, also the depth will effectively increase due to the expansion of the patterned layer perpendicular to the substrate. If the opening is closed at at least a longitudinal extremity by the presence of the patterned layer, the method according to embodiments of the present invention will reduce the length of this opening. This situation is represented in Fig. 9A, B, and D.

If the opening is closed at at least a lateral extremity by the presence of the patterned layer, the method according to embodiments of the present invention will reduce the width of this opening. This situation is represented in Fig. 9A, B and C.

If the opening is closed at at least a lateral extremity and at at least a longitudinal extremity by the presence of the patterned layer, the method according to embodiments of the present invention will reduce both the width and the length of this opening. This situation is represented in Fig. 9A and B.

If the opening is open at both its longitudinal extremities due to the absence of the patterned layer thereat, and is closed at both its lateral extremities by the presence of the patterned layer thereat, the method according to embodiments of the present invention may increase the length of this opening and will decrease the width of this opening. This situation is represented in Fig. 9C.

If the opening is open at both its lateral extremities due to the absence of the patterned layer thereat, and is closed at both its longitudinal extremities by the presence of the patterned layer thereat, the method according to embodiments of the present invention may increase the width of this opening and will decrease the length of this opening. This situation is represented in Fig. 9D. Although possible, this situation is not as advantageous as the situations represented by Fig.9A, B, and C since an advantage of the present invention is its ability to achieve an opening with a width smaller than currently achievable by other techniques. Reducing the length is less interesting because it is typically longer than the width.

The extent of the reduction will typically depend on the method of infiltration that is used and may, for example, include a number of repetition cycles, a duration (e.g. of exposure), a concentration or partial pressure of a material, a reaction temperature, etc. In embodiments, the width and or length may be reduced by repeating a sequence comprising step b1 and step b2. In embodiments, a sequence comprising step b1 and step b2 may be performed from 1 to 10 times. The absolute reduction in width and/or length is typically relatively linear with respect to the number of cycles and is thus advantageously well controllable. The number of cycles can, of course, be increased beyond 10. Also, reducing the duration of each exposure step may require a larger number of cycles for an equivalent reduction in width and/or length. Similarly, an equivalent reduction of width and/or length may be obtained after fewer cycles by using a higher partial pressure and/or longer exposure times of the precursors. The important criterion is that, for a given set of exposure conditions, the cycle is repeated until the desired reduction in width and/or length of the opening is achieved.

Infiltration of the patterned layer with a metal or ceramic material is performed selectively with respect to the substrate. This is advantageous to allow a good etch selectivity and a good quality of the transferred pattern. In embodiments, the opening may expose a surface of the substrate, the surface belonging to a layer of a material not comprising oxygen atoms (i.e. free of oxygen atoms) in its general formula. In preferred embodiments, the surface may comprise a soft material (cf. supra). The surface may, for example, comprise an organic material, such as a polymer not comprising oxygen atoms, e.g. not comprising any hydroxyl, alkoxy or carbonyl functional groups. The surface may, for example, be the surface of a layer of the organic material. The layer of organic material may, for example, be from 5 to 7 nm thick. The polymer may, for example, be a polystyrene, such as a crosslinked polystyrene (x-PS). Without being bound by theory, it is believed that the first precursor may diffuse into a soft material and bind therein to oxygen atoms, preventing it from being removed during a subsequent purging step and enabling it to react therein with the second precursor, resulting in a metal or ceramic material being infiltrated. Trimethylaluminium is for example known to bind reversibly to carbonyl functional groups and irreversibly to hydroxyl or alkoxy functional groups; furthermore, the oxygen in the aluminum oxide, formed from oxidizing the trimethylaluminium, typically acts as a further binding site in later SIS cycles. Conversely, if no oxygen atoms are present in the exposed substrate (e.g. in the soft material), the first precursor is typically flushed out during the purging phase and no first precursor is left in the material to react with the second precursor, thus no metal or ceramic material is infiltrated. As such, one can advantageously control which substrate will be infiltrated by means of the presence or absence of oxygen atoms therein. In other embodiments, the surface may comprise a hardmask material. Hardmask materials are typically denser than soft materials, thus not allowing the first precursor from diffusing therein and therefore preventing infiltration by the metal or ceramic material. The hardmask material may preferably not comprise oxygen atoms. The hardmask material may, for example, be SiN, TiN or AIN. Even if the first precursor cannot diffuse into the hardmask material, the first precursor may still bind to oxygen atoms at the surface of a material such as SiOC, SiO₂ or SiON.

The present invention may further relate to a method for patterning a substrate, comprising performing the method according to any embodiment of the first aspect (i.e. making the mask layer) and further comprising performing a step c, after step b, of:
c. selectively etching, through the opening having the reduced width and/or length, the substrate with respect to the infiltrated patterned layer.

Selectively etching the substrate with respect to the infiltrated patterned layer may comprise selectively etching the substrate at least with respect to the metal or ceramic material. In embodiments, the etching may comprise a plasma etching. A soft layer such as a polystyrene or cross-linked polystyrene layer may, for example, be selectively etched using an N₂/H₂, an N₂/O₂ or an Ar/O₂ plasma etching. A hardmask layer such as SiN may, for example, be selectively etched using a CH₃F/O₂/Ar plasma. In embodiments, the method for patterning the substrate may, for example, be used in the formation of quantum dots or single electron transistors, such as used for quantum computing (e.g. solid-state room temperature quantum computing). In other embodiments, the method for patterning the substrate may, for example, be used in the formation of a nanopore transistor, such as used in nanopore transistor-based DNA sensing (where e.g. the patterning of a nanopore having a width smaller than 10 nm, preferably smaller than 2 nm, is desirable). In yet other embodiments, the method for patterning the substrate may, for example, be used to pattern thin trenches, e.g. in a dielectric material.

In embodiments, the method may comprise a further step of removing the infiltrated patterned layer, for example using dry or wet etching solutions.

In embodiments, any feature of any embodiment of the first aspect may independently be as correspondingly described for any embodiment of any of the other aspects.

In a second aspect, the present invention relates to an assembly comprising a mask layer on a substrate, obtainable by the method according to any embodiment of the first aspect.

For instance, in an embodiment, the present invention may relate to an assembly comprising a mask layer on a substrate, the mask layer being a patterned layer comprising at least one opening exposing the substrate, the patterned layer being infiltrated with a concentration of a metal or ceramic material, the substrate being not infiltrated with the metal or ceramic material or being infiltrated with a lower concentration thereof.

In embodiments, any feature of any embodiment of the second aspect may independently be as correspondingly described for any embodiment of any of the other aspects.

In a third aspect, the present invention relates to a use of sequential infiltration synthesis for reducing a width of an opening in a patterned layer.

In embodiments, the opening may be formed using a scanning probe lithography, such as a thermal scanning probe lithography.

In embodiments, any feature of any embodiment of the third aspect may independently be as correspondingly described for any embodiment of any of the other aspects.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example 1: Sequential infiltration synthesis (SIS) into a polyphtalaldehyde (PPA) film

One or more SIS cycles were performed on a PPA film, each cycle comprising exposing the PPA film to trimethylaluminium (first precursor) in a reaction chamber at a partial pressure of 0.1 Torr for 400 s/cycle, purging the reaction chamber with N₂ for 20 s (inert gas), subsequently exposing the PPA film to water (second precursor) for 20 s and purging the reaction chamber again with N₂ for 2 min. The SIS process was done at 25 °C, unless otherwise specified. The nature of the infiltrated aluminum oxide (ceramic material) was investigated using various techniques.

### Example 1a: Distribution of the infiltrated aluminum oxide

In a first sample, a PPA film with a thickness of in the range of from 10 to 26 nm is provided on a substrate and one cycle of SIS is performed on the PPA film as previously described. The infiltration of aluminum oxide into the PPA film was investigated by elemental analysis using angle resolved X-ray photoelectron spectroscopy (ARXPS) and elastic recoil detection (ERD).

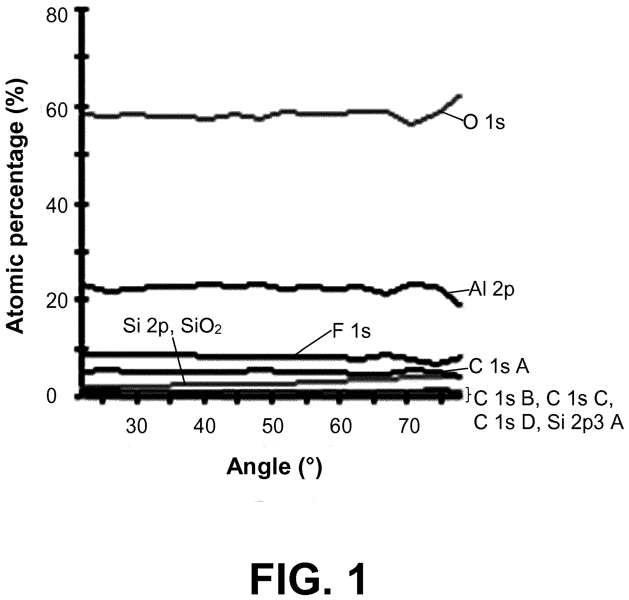

We now refer to Fig. 1, showing the atomic percentage in function of the angle of incidence, obtained using XPS on the first sample, for different atomic orbitals. The relatively flat curves which were obtained indicated an even distribution of the infiltrated aluminum oxide over the investigated film thickness.

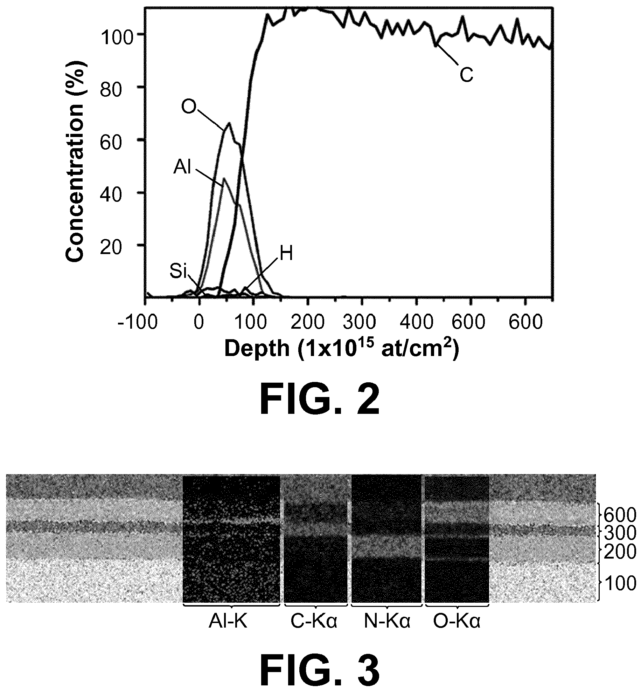

We now refer to Fig. 2, showing the elemental composition in function of the depth, obtained using ERD on the first sample. It was seen that Al and O, both attributed to the aluminum oxide, infiltrated about 10 nm into the PPA film. Furthermore, some Al and O were observed to be present in a layer of about 5 nm outside the PPA film.

We now refer to Fig. 3. In a second sample, the substrate comprised a Si wafer (100) with a 13 nm thick SiN layer (200) and a 7 nm thick cross-linked polystyrene (x-PS) layer (300) thereon. A PPA layer of about 11 nm was provided on the x-PS layer (300) and a single SIS cycle was performed as previously described to form an infiltrated PPA layer (600). An elemental analysis of the second sample was performed using transmission electron microscopy (TEM) energy dispersive x-ray spectroscopy (EDS); this is shown in Fig. 3 consisting of the combined raw maps for all investigated energies (elements) overlayed in selected areas with the corresponding maps for the single elements Al, C, N, and O (based on their spectral lines Kα). In Fig. 3, any lighter spot indicates the presence of a measure energy (element) at that spot whereas a black spot indicates the absence thereof. From the Al map, it could be observed that aluminum oxide infiltrates into the PPA layer (600) selectively with respect to the x-PS layer (300). Furthermore, it was seen that the aluminum oxide mostly concentrates into an Al rich layer at the top and the bottom of the PPA layer (400) at the first few cycles and distributes evenly across the bulk of the PPA as the number of cycles increases. Additionally, a small presence of Al could be seen near the x-PS (300)/SiN (200) interface. On the O map, two O rich layers near the x-PS (300)/SiN (200) and the SiN (200)/Si (100) interface could be observed; these were attributed to two native oxide layers. As such, it is tentatively suggested that the SIS precursors may be able to penetrate the PPA layer (600), without binding thereto, up to the SiN's (200) native oxide layer. In this view, the SIS precursors do not bind to the PPA layer (600) due to the lack of O therein but may bind to the O in the native oxide layer.

### Example 1b: PPA film thickness after infiltration

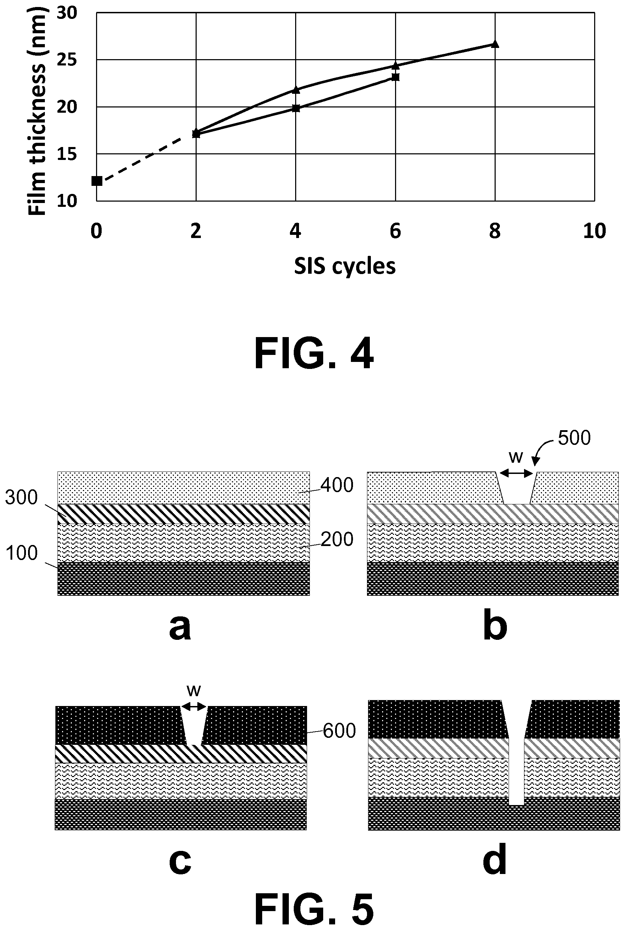

We now refer to Fig. 4, showing the thickness of a PPA film in function of the number of cycles for a SIS process performed at 80 °C (triangles) and 90 °C (squares). For both temperatures, an almost linear increase of the film thickness could be observed for an increasing number of SIS cycles.

While Fig. 4 relates to the expansion of the PPA film in the direction perpendicular to the film (i.e. the thickness), it is believed (see example 2) that a similar expansion occurs in directions parallel to the film (e.g. the width or length). As such, when an opening is present in the PPA film, the film increasingly expands in the parallel directions with each SIS cycle and thereby reduces the width of the opening.

### Example 2: Sequential infiltration synthesis SIS) into a patterned polyphtalaldehyde (PPA) layer and subsequent pattern transfer

### Example 2a: Patterning of a polyphtalaldehyde (PPA) layer

We now refer to Fig. 5a. A sample was provided, similar to the second sample of example 1b: the substrate comprised a Si wafer (100) with a 13 nm thick SiN layer (200) and a 7 nm thick cross-linked polystyrene (x-PS) layer (300) on the SiN layer (200), and a PPA layer (400) of about 11 nm was provided on the x-PS layer (300).

We now refer to Fig. 5b. At least one opening with a width (w) was formed in the PPA layer (400) using a thermal scanning probe lithography (tSPL). Openings with a width as small as 9 nm or lower and a pitch as low as 9.5 nm or lower can be formed into the PPA using tSPL.

### Example 2b: SIS into the patterned PPA layer

We now refer to Fig. 5c. One or more SIS cycles were performed on the PPA layer (400) to form an infiltrated PPA layer (600), thereby reducing the width (w) of the opening. Each cycle comprised exposing the PPA layer (400) to trimethylaluminium (first precursor) in a reaction chamber at a partial pressure of 0.1 Torr for 400 s/cycle, purging the reaction chamber with N₂ for 20 s (inert gas), subsequently exposing the PPA layer (400) to water (second precursor) for 20 s and purging the reaction chamber again with N₂ for 2 min. The SIS process was done at 25 °C. Starting from an opening with a small width (w; e.g. 12 nm or lower) and using a sufficient number of SIS cycles, an opening with a width (w) of 5 nm or lower can be obtained. It is noteworthy that the PPA layer, when not infiltrated, degrades thermally at room temperature within a few weeks while the infiltrate PPA layer does not show any signs of thermal degradation at room temperature over a corresponding period.

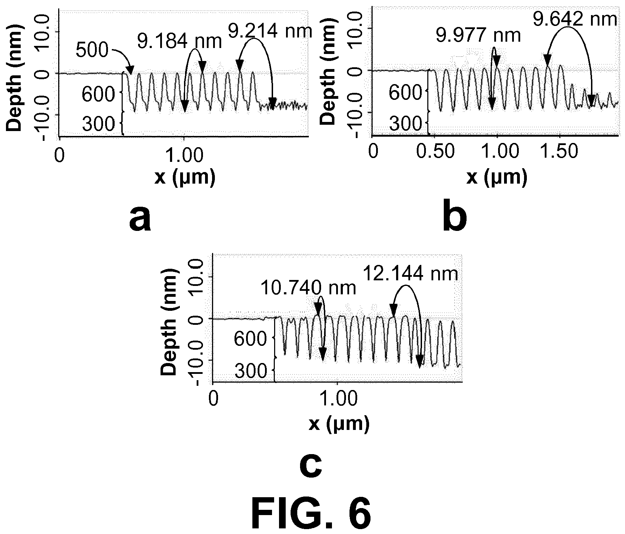

We now refer to Fig. 6, showing atomic force microscopy (AFM) depth profiles along a direction x for samples with a plurality of openings pitched at 100 nm and having undergone one (Fig. 6a), two (Fig. 6b) or four (Fig. 6c) SIS cycles. Also shown in Fig. 6 are depth readouts as measured between the tips of each pair of the indicated arrows. The infiltration occurred selectively into the infiltrated PPA layer (600), with respect to the x-PS layer (300). It was observed that the infiltrated PPA layer (600) further expands for each additional SIS cycle. This expansion occurred both perpendicularly to the substrate, effectively deepening each opening, and parallel to the substrate, narrowing each opening.

### Example 2c: Pattern transfer

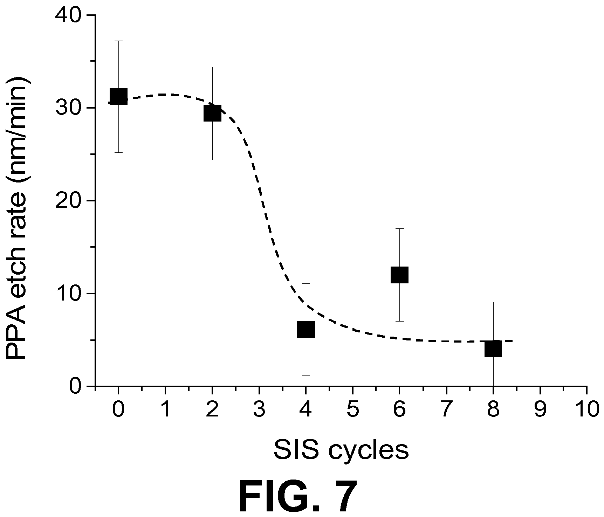

We now refer to Fig. 7, showing the measured PPA etch rate for an N₂/H₂ plasma etch in function of the number of SIS cycles. It was seen that four or more SIS cycles increased the etch resistance of PPA by a factor of about four, as compared to a pure PPA film (i.e. zero SIS cycles).

We now refer to Fig. 5d. The pattern in the infiltrated PPA layer (600) is transferred to the substrate by plasma etching the x-PS layer (300) using an N₂/H₂ based chemistry. The pattern is further transferred by plasma etching the SiN layer (200) using a CH₃F/O₂/Ar based chemistry; it was observed that this etch recipe may also recess the Si wafer.

We now refer to Fig. 8, showing AFM depth profiles along a direction x after SIS (Fig. 8a), after etching the x-PS layer (300) (Fig. 8b) and after etching the SiN layer (200) (Fig. 8c). Also shown in Fig. 8 are depth readouts as measured between the tips of each pair of the indicated arrows. The measured depth of 5 nm in Fig. 8b might indicate a not yet completed etch of the x-PS layer, but, nevertheless, the complete etch is seen in Fig. 8c. Since the layer thickness of the x-PS layer (300) and the SiN layer (200) is known (i.e. 7 nm and 13 nm respectively), the full etching of these layers can be inferred from the measured depths of the openings in Fig. 8c (e.g. 22nm). The slightly higher measured depth compared to the sum of the x-PS layer (300) and SiN layer (200) may either be due to the presence of some Al₂O₃ on top, adding to the depth, or due to a slight etching into the Si wafer (100). Nevertheless, it could thus be confirmed that the pattern in the PPA layer (200) can be successfully transferred into the x-PS layer (300) and into the SiN layer (200).

Additional measurements, which are not shown, were performed for etching beyond the SiN layer into the Si wafer. TEM analysis of the corresponding samples indicated a nice pattern transfer into the SiN and 60 nm deep into the Si wafer.

Fig. 9 shows schematic representations of top views of patterned layers (400) on a substrate (300) (top) and mask layers (600) on the substrate (300) (bottom) for openings (500) differing in shape. Fig. 9A shows how a circular opening sees its diameter and therefore both its length and its width (which are equal) reduced during a method according to an embodiment of the present invention. Fig. 9B shows how a rectangular opening closed at both its lateral extremities and both its longitudinal extremities sees both its length and its width reduced during a method according to an embodiment of the present invention. Fig. 9C shows how a rectangular opening (a trench) closed at both its lateral extremities and open at both its longitudinal extremities sees its length augmented and its width reduced during a method according to an embodiment of the present invention. Fig. 9D shows how a rectangular opening open at both its lateral extremities and closed at both its longitudinal extremities sees its width augmented and its length reduced during a method according to an embodiment of the present invention.

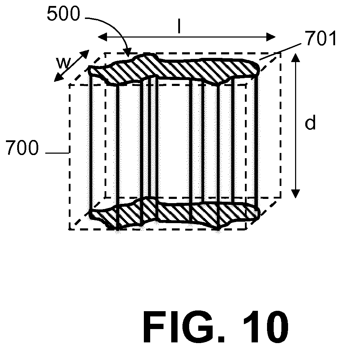

Figure 10 defines the length (I), width (w) and depth (d) of a right cylinder opening (500) having irregular bases as being respectively the length (I), width (w) and depth (d) of its minimum bounding cuboid (700) having a face (701) parallel to the surface of the substrate.

It is to be understood that although preferred embodiments, specific constructions and configurations, as well as materials, have been discussed herein for devices according to the present invention, various changes or modifications in form and detail may be made without departing from the scope and technical teachings of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for making a mask layer (600), comprising:
a. providing a substrate (100, 200, 300) having a patterned layer (400) thereon, the patterned layer (400) comprising at least one opening (500), the opening (500) exposing the substrate (100, 200, 300) and having a width (w) and a length (I), and
b. infiltrating the patterned layer (400) with a metal or ceramic material, selectively with respect to the substrate (100, 200, 300);
wherein step b is performed to such an extent that at least one of the width (w) and the length (I) is reduced by at least 20%, preferably at least 35%, yet more preferably at least 50%, thereby forming the mask (600).

2. The method according to claim 1, wherein the width (w) before step b measures 100 nm or less, preferably 50 nm or less, yet more preferably 20 nm or less.

3. The method according to claim 2, wherein the width (w) measures from 7 to 20 nm, preferably from 10 to 15 nm, before step b and measures from 1 to 10 nm, preferably from 2 to 5 nm, after step b.

4. The method according to any of the previous claims, wherein the patterned layer (400) is a patterned resist layer (400) and wherein step a comprises:
a1. providing a substrate (100, 200, 300) having a resist layer (400) thereon, and
a2. patterning the opening (500) into the resist layer (400) using a lithography.

5. The method according to claim 4 wherein the lithography is a thermal scanning probe lithography.

6. The method according to any of the previous claims, wherein the patterned layer (400) comprises a polyphtalaldehyde.

7. The method according to any of the previous claims, wherein the ceramic material is an aluminum oxide, a titanium oxide, a silicon oxide, a rubidium oxide or a hafnium oxide.

8. The method according to any of the previous claims, wherein step b comprises a sequential infiltration synthesis.

9. The method according to claim 8, wherein the sequential infiltration synthesis comprises:
b1. exposing the patterned layer (400) to a first precursor, and
b2. exposing the patterned layer (400) to a second precursor.

10. The method according to claim 9, wherein the first precursor is trimethylaluminium and wherein the second precursor is an oxidant.

11. The method according to claim 9 or 10, wherein the width (w) is reduced by repeating a sequence comprising step b1 and step b2.

12. The method according to any of the previous claims, wherein the opening (500) exposes a surface of the substrate (100, 200, 300) and wherein the surface is made of an organic material free of oxygen atoms.

13. A method for patterning a substrate (100, 200, 300), comprising performing the method according to any of the previous claims and further comprising performing a step c, after step b, of:
c. selectively etching, through the opening (500) having the reduced width and/or length, the substrate (100, 200, 300) with respect to the mask (600).

14. An assembly comprising a mask layer on a substrate (100, 200, 300), the mask layer being a patterned layer comprising at least one opening exposing the substrate, the patterned layer being infiltrated with a concentration of a metal or ceramic material, the substrate being not infiltrated with the metal or ceramic material or being infiltrated with a lower concentration thereof.

15. Use of sequential infiltration synthesis for reducing a width (w) of an opening (500) in a patterned layer (400).
